# EUROPEAN PATENT SPECIFICATION

(11) **EP 0 499 412 B1**
(45) Date of publication and mention of the grant of the patent: **19.04.2000**
(21) Application number: 92301031.8
(22) Date of filing: 07.02.1992
(51) Int. Cl.: G06F 7/52

(54) **Serial-input multiplier circuits**
Multiplizierer-Schaltungen mit seriellem Eingang
Circuits de multiplication à entrée sérielle

(30) Priority: 12.02.1991 JP 1894091; 12.02.1991 JP 1893991
(43) Date of publication of application: 19.08.1992
(73) Proprietor: SONY CORPORATION, Tokyo 141 (JP)
(72) Inventor: Ohki, Mitsuharu, c/o Patents Division, Sony Corp., Tokyo 141 (JP)
(74) Representative: Cotter, Ivan John

(56) References cited:
- IEE PROCEEDINGS E. COMPUTERS & DIGITAL TECHNIQUES vol. 138, no. 1, January 1991, STEVENAGE GB pages 21 - 26 , XP000179680 AIT-BOUDAOUD ET AL 'Novel cell architecture for bit level systolic arrays multiplication'
- MICROPROCESSING AND MICROPROGRAMMING vol. 24, no. 1-5, August 1988, AMSTERDAM NL pages 637 - 645 BREVEGLIERI 'Design and implementation of a VLSI serial multiplier for fixed point numbers with self-checking capability'

## Description

This invention relates to serial-input multiplier circuits in which a series of serially input digital data and a predetermined coefficient are multiplied to derive a serial-output multiplied result.

Multiplier circuits are known for calculating a product of input data I of word length n bits sequentially updated, and a predetermined coefficient C with a plurality of bits. Assuming that the word length of the coefficient C is seven bits, for example, then the input data I and the coefficient C are expressed as follows, where the most significant bit (MSB) (the highest bit) is to the left:$\begin{matrix}\begin{matrix}\text{I = (In-1, In-2, ..., I0),} \\ \text{C = (C6, C5, ..., C0)}\end{matrix}\end{matrix}$

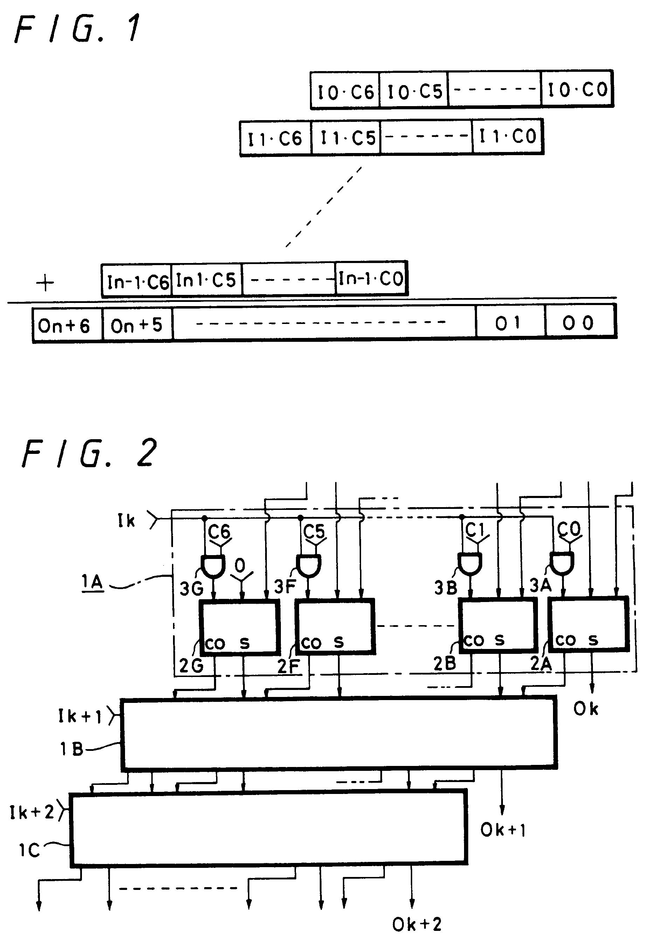

In that case, the product O of the input data I and the coefficient C can be expressed as follows:$\text{O = (On+6, On+5, ..., 01, 00)}$ The multiplication for calculating this product O is expressed by the addition of partial products as shown in Figure 1.

Figure 2 shows in block form a multiplier circuit which is used to execute the calculation shown in Figure 1.

Referring to Figure 2, processing units 1A, 1B, 1C, ... of the same form are supplied with data Ik, Ik+1, Ik+2, ... of respective bits of the input data I and output data Ok, Ok+1, Ok+2, ... of respective bits of the product O. The processing unit 1A, for example, comprises seven full adders 2A to 2G and seven AND gates 3A to 3G. Data C0 to C6 of the coefficient C are respectively supplied to one terminal of the AND gates 3A to 3G, and data Ik are commonly supplied to the other input terminals of the AND gates 3A to 3G. The adders 3A to 3G are respectively supplied at their input portions with the outputs of the AND gates 3A to 3F, sum outputs of the processing units of the preceding stage, and carry outputs. The adder 2G of the highest digit is supplied at its input portion with an output of the AND gate 3G, data '0', and a carry output of the highest digit from the processing unit of the preceding stage.

The multiplier circuit of Figure 2 is formed by the repetition of the processing unit 1A, so that, if the processing unit 1A is used in a time division manner, then the multiplier circuit can be made smaller. If the processing unit is utilized in a time division fashion, then respective bits of the input data I are serially input, and respective bits of the product O which are the multiplied result are output serially.

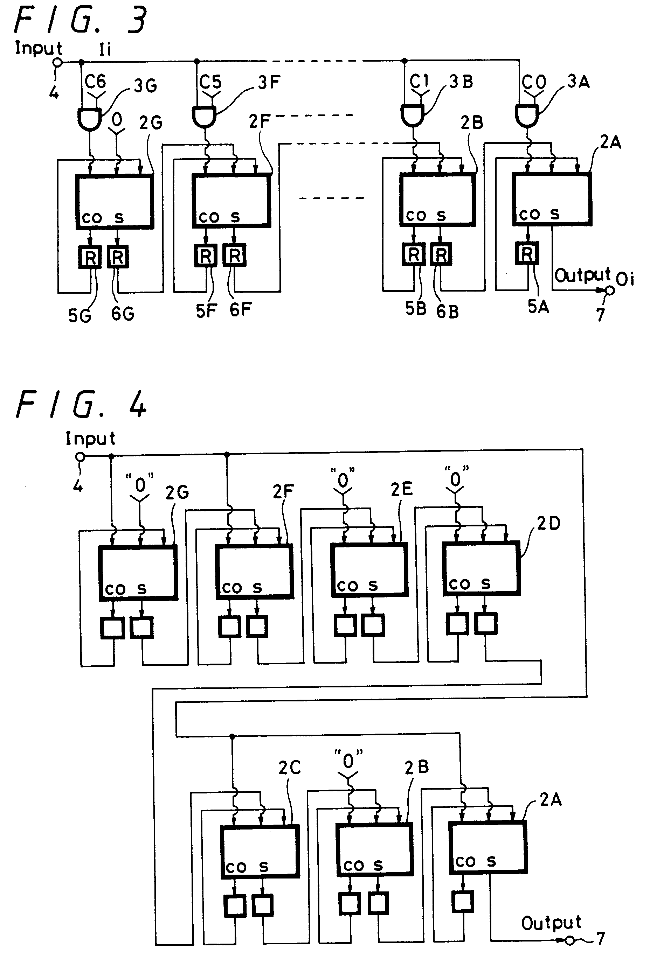

Figure 3 shows in block form a multiplier circuit which inputs and outputs data serially in one such time division fashion. In this multiplier circuit, data C0 to C6 of respective bits of the coefficient C are respectively supplied to one input terminal of the AND gates 3A to 3G, and outputs of the AND gates 3A to 3G are respectively supplied to one input terminal of the full adders 2A to 2G. The other input terminals of the AND gates 3A to 3G are commonly connected to an input terminal 4, and a sum output terminal of the adder 2A of the lowest (least significant) digit is connected to an output terminal 7. Carry outputs of the full adders 2A to 2G are respectively fed through one clock delay registers 5A to 5G back to their own other input terminals, and sum outputs of the adders 2B to 2G are respectively supplied through one clock delay registers 6B to 6G to the remaining input terminals of the adders 2A to 2F of the next lower digit. The multiplier circuit shown in Figure 3 is described, for example, at page 62 and in Figure 4.2 of 'application of digital signal processing' by Nobuo Inoue and published by the Institute of Electronics and Communication Engineers of Japan, and also in IEE proceedings - E 138 (1991) Jan. No. 1, Pages 21 -23: "Novel cell architecture for bit level systolic arrays multiplication" by Boudaoud et al.

In the example of Figure 3, from the input terminal 4, respective bits Ii of input data I are supplied in the sequential order of I0 in the first cycle, I1 in the second cycle, ..., In-1 in the n'th cycle to the AND gates 3A to 3G, and respective bits of product 0 are output from the output terminal 7 in the sequential order of 00 in the first cycle, 01 in the second cycle, ..., On+6 in the (n+7)'th cycle. To be more specific, if the coefficient C is set as follows:$\text{C = (C6, C5, C4, C3, C2, C1, C0) = (1100101)}$ then the circuit shown in Figure 3 is simplified and becomes equivalent to a circuit shown in Figure 4. Thus, in the circuit shown in Figure 4, although the respective input terminals of the adders 2A, 2C, 2F and 2G of the digit in which the bit Ci of the coefficient C is '1' in the circuit of Figure 3, are connected to the input terminal 4, the respective input terminals of the adders 2B, 2D and 2E of the digit in which the bit Ci of the coefficient C is '0' are not connected to the input terminal 4.

Accordingly, although the four adders 2A, 2C, 2F and 2G execute useful processing, by adding bit Ii of input data I supplied thereto through the input terminal 4, the remaining three adders 2B, 2D and 2E execute useless processing for adding '0', instead of adding data Ii of respective bits of the input data I.

To generalize this, assuming that the coefficient C is a bits and that m1 bits '1' and m2 ($\text{m2=m-m1}$) bits '0' exist within the bit Ci of the coefficient C, then it is to be noted that m/2 full adders of m full adders within the circuit of Figure 4 execute useless processing. If the full adders, which do not execute useful processing, are removed, then the multiplier circuit can be made smaller and cheaper.

Moreover, the above multiplier circuit needs a calculation time corresponding to a number of cycles equal to the word length of the resultant product.

More specifically, assuming that the word length of input data I, J, K, ... is six bits and that the word length of the coefficient C is six bits, then the word length of the products O, P, Q, ... is twelve bits. Therefore, the input data I, the coefficient C and the product O can be expressed in a binary numeral fashion as follows where the bit (MSB) of the higher digit is to the left:$\begin{matrix}\begin{matrix}\text{I = (I5, I4, I3, I2, I1, I0)} \\ \text{C = (C5, C4, C3, C2, C1, C0) (1)} \\ \text{O = I x C = (O11, O10, O9, ..., O1, O0)}\end{matrix}\end{matrix}$

Similarly, input data J can be expressed as (J5, J4, ..., J0), and product P also can be expressed as (P11, P10, ..., P1, P0). Therefore, input data and product will hereinafter be expressed in a binary numeral fashion.

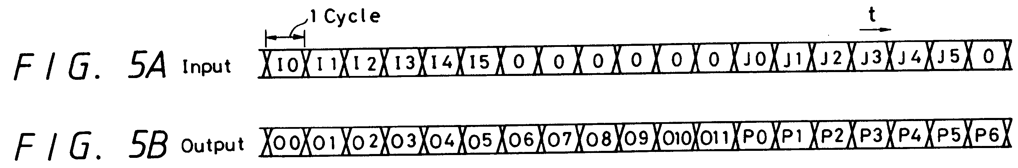

In that case, respective bits of input data I, J, ..., must be supplied in the format such that a dummy bit formed of six '0's is interposed therebetween as shown in Figure 5A. The reason for this will be described below. That is, since the known multiplier circuit for multiplying the numbers of word length six bits is formed such that six full adders are connected in series via delay circuits, a time period of six cycles is needed until a calculated result is output to the output terminal through the delay circuit, full adders provided on the right of the delay circuit, full adders provided on the right of the delay circuit or the like, after data of I5, J5 of MSBs such as input data I, J or the like have been input to the left-most full adder. Therefore, the next data cannot be input during that period. This multiplier circuit generaties at its output terminal respective bits such as O, P or the like sequentially in response to Figure 5A, as shown in Figure 5B.

However, the dummy bits must be inserted between input data I, J or the like as shown in Figure 5A, and there is then the disadvantage such that a signal line (bus) for tranmitting input data cannot be utilized effectively. Furthermore, although the data rate of the input data is the critical time in the calculation in such a multiplier circuit, the insertion of the dummy bit increases the calucluation time considerably.

According to the present invention there is provided a serial-input -output multiplier circuit according to claim 1.

According to the present invention there is also provided a serial-input-output multiplier circuit according to claim 2.

The invention will now be described by way of example with reference to the accompanying drawings, throughout which like parts are referred to by like references, and in which:
Figure 1 is a schematic representation used to explain a known calculating method;
Figure 2 is a schematic block diagram showing a first example of a knwon parallel input multiplier circuit;
Figure 3 is a schematic block diagram showning a second example of a known serial input multiplier circuit;
Figure 4 is a schematic block diagram showing an example of an equivalent circuit of the multiplier circuit of Figure 3;
Figures 5A and 5B are timing charts for explaining the multiplier circuit of Figure 3;
Figure 6 is a schematic block diagram showing a first embodiment of multiplier circuit according to the present invention;
Figure 7 is a block diagram showing an example of a variable delay circuit used in the embodiment of Figure 6;
Figures 8 and 11 are schematic block diagrams showing examples of equivalent circuits of the embodiment of Figure 6;
Figures 9 and 10 are schematic block diagrams showing examples of an equivalent circuit of the multiplier circuit of Figure 2;
Figure 12 is a schematic block diagram showing part of the embodiment of Figure 6;
Figure 13 is a schematic block diagram showing a modified example of the part shown in Figure 12;
Figure 14 is a schematic block diagram showing a second embodiment of multiplier circuit according to the present invention;
Figures 15 and 16 are respectively schematic block diagrams showing a third embodiment of multiplier circuit according to the present invention;
Figures 17A to 17C are respectively timing charts used to explain operation of the embodiment of Figures 15 and 16;
Figure 18 is a schematic block diagram showing a modified form of the embodiment of Figure 15; and
Figure 19 is a schematic block diagram showing a fourth embodiment of multiplier circuit according to the present invention.

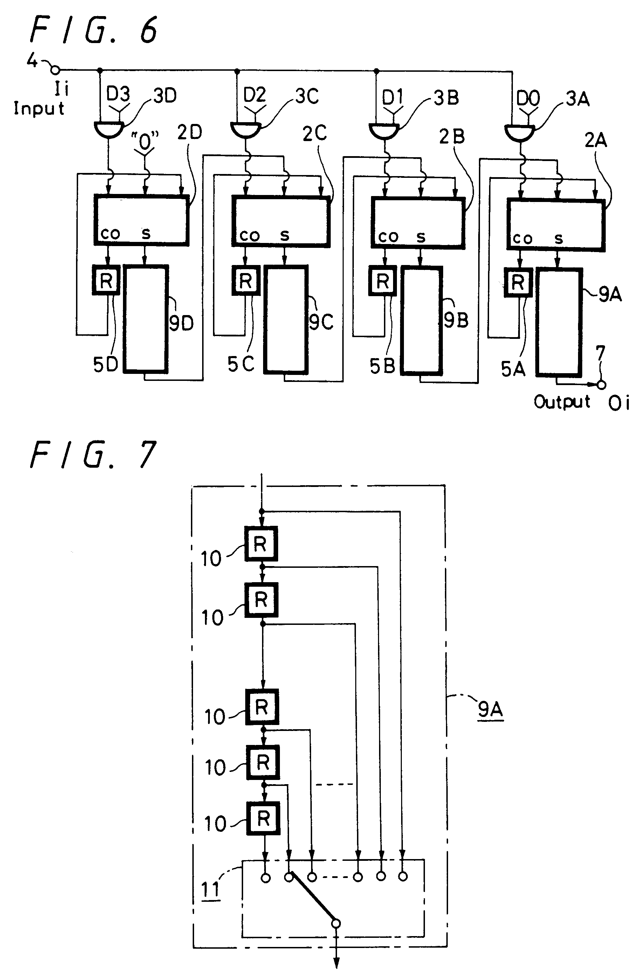

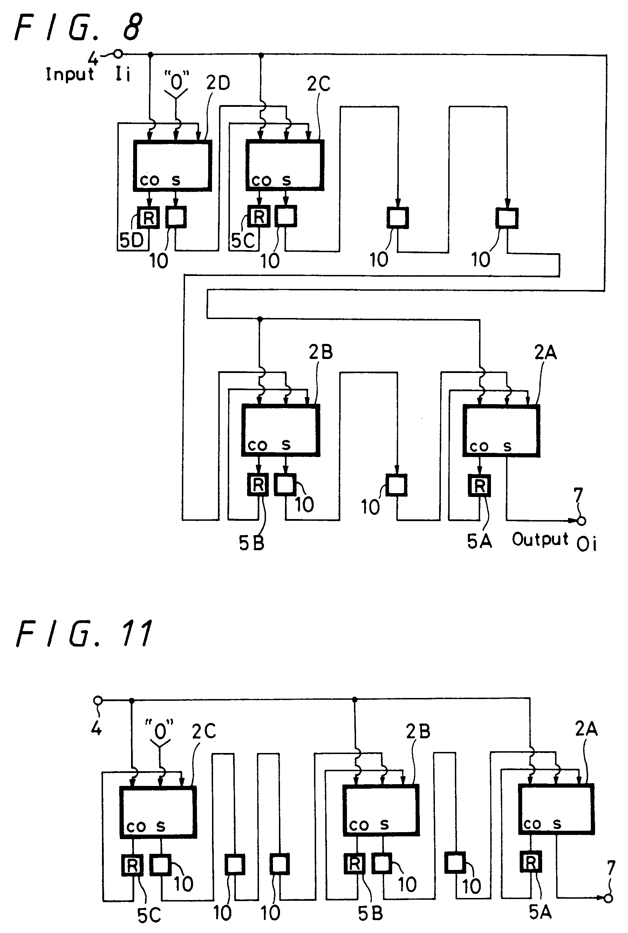

The first embodiment of a serial-input multiplier circuit according to the present invention will now be described with reference to Figures 6 to 12. In this embodiment, the invention is applied to a multiplier circuit in which input data I of word length n bits (n is an integer larger than two) serially input from the LSB (least significant bit) and a coefficient C of word length m bits (m is an integer of four or more) are multiplied with each other to obtain a product O of word length (n+m) bits, and respective bits of the product O are serially output from the LSB. With the MSB to the left, the input data I, the coefficient C, and the product O can be expressed as follows:$\begin{matrix}\begin{matrix}\text{I = (In-1, In-2, ..., I0)} \\ \text{C = (Cm-1, Cm-2, ..., C0)} \\ \text{O = (On+m-1, On+5, ..., O1, O0)}\end{matrix}\end{matrix}$

In this embodiment, assuming that four bits '1' exist within respective bits of the coefficient C at most, then four bits which will become '1' are represented as coefficient data D0, D1, D2, D3 in the sequential order of less significant digits. That is, the coefficient C can be expressed by the use of bits Di as follows:$\text{C= (D3, ..., D2, ..., D1, ..., D0, ...)}$ In the above equation (3), -...- comprises series of '0's. For example, if C = (1100101), then $\text{D0 = D1 = D2 = D3 = 1}$ and if C = (100101), then $\text{D0 = D1 = D2 = 1}$, D3 = 0.

Figure 6 shows a multiplier circuit according to the first embodiment. This embodiment employs four full adders 2A to 2D, the number of which corresponds to that of coefficient data Di, and four AND gates 3A to 3D. Respective bits Ii of the input data I are serially supplied through the input terminal 4 to one input terminal of the AND gates 3A to 3D, and coefficient data D0 to D3 are respectively supplied to the other input terminals of the AND gates 3A to 3D. Outputs of the AND gates 3A to 3D are respectively supplied to one input terminal of the adders 2A to 2D. Carry outputs of the adders 2A to 2D are fed through registers 5A to 5D, each of which is provided as a unit delay element, back to other input terminals of their own. Sum outputs of the more significant three digits from the adders 2B and 2D are respectively supplied through variable delay circuits 9B to 9D to remaining input terminals of the adders 2A to 2C at their lower digits, and data '0' are supplied to one remaining input terminal of the adder 2D of the maximum digit. A sum output of the adder 2A of the minimum digit is supplied through a variable delay circuit 9A to the output terminal 7 as respective bits of product Oi.

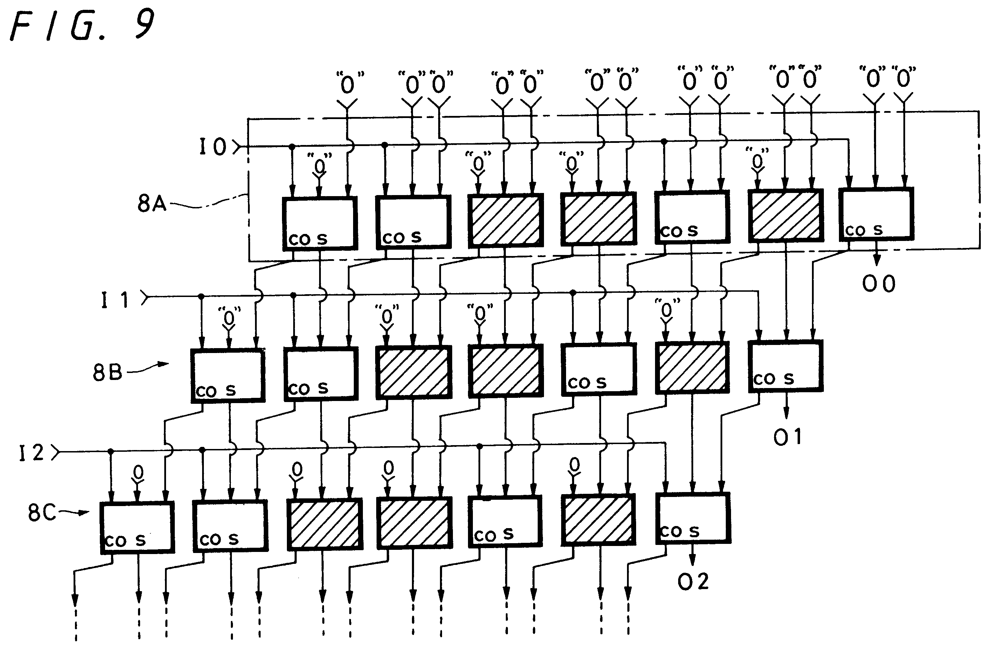

Each of the variable delay circuits 9A to 9D is of the same form, and an example of the variable delay circuit 9A is illustrated in Figure 7. Referring to Figure 7, registers 10 are respectively provided as unit delay elements. Since the word lengths of the coefficient C and the input data I to be multiplied therewith are both m bits, m registers 10 are connected in cascade, and the sum output of the adder 2A of Figure 6 is supplied to the leading register 10. Further, a data selector 11 is designed to output one datum in response to the input of (m+1) data. Output data of m registers 10 and the input data to the leading register 10 are respectively supplied to the input terminals of the data selector 11, and an output of the data selector 11 is supplied to the output terminal 7 shown in Figure 6. In this case, assuming that one clock represents a cycle in which input data are moved bit by bit, then by supplying a control signal to the data selector 11 from the outside, data in which the input data are delayed by O to m clocks can be obtained from the variable delay circuit 9A.

The operation of the embodiment will now be described, in the case where the coefficient C is (1100101). In this case, $\text{D0 = D1 = D2 = D3 = 1}$ is set in Figure 6, and the delay times of the variable delay circuits 9A to 9D are respectively set to 0, 2 clocks, 3 clocks and 1 clock. At that time, since the AND gates 3A to 3D output input data directly, the multiplier circuit shown in Figure 6 becomes equivalent to the multiplier circuit shown in Figure 8. On the other hand, the equivalent circuit in which the coefficient C is set to (1100101) in the multiplier circuit according to the prior example shown in Figure 3 is represented in Figure 4. Therefore, operation in which the circuit shown in Figure 8 executes the multiplication of the input data I and the coefficient C similarly to the circuit shown in Figure 4 will be described below.

The multiplier circuit shown in Figure 2 is supplied with data I0, I1, ..., In-1 in parallel at the same timing and multiplies the input data with the coefficient C ($\text{C = C6, C5, ..., C0}$). If C = (1100101) is set in this multiplier circuit, then AND gates can be removed, so that the first stage portion of the circuit of Figure 2 is modified as shown in Figure 9. The multiplier circuit of Figure 9 is formed by repeatedly connecting in cascade processing units 8A, 8B, 8C, ..., each of which is composed of seven full adders. Further, since $\text{C4 = C3 = C1 = 0}$ in Figure 9, the three hatched full adders in the processing unit 8A of the first stage do not add the coefficient C to the input data I0, and two data of '0' are supplied to these three hatched adders as initial values. Consequently, sum outputs and carry outputs of these three adders are all '0'.

In the processing unit 8B of the second stage, since data '0' are supplied to at least two input terminals of three input terminals of three adders (hatched in Figure 9) corresponding to the coefficients C1, C3 and C4, carry outputs of these three adders are all '0'. Similarly, in the processing unit 8C of the third stage, since carry outputs of three hatched adders corresponding to the coefficients C1, C3 and C4 are all '0', these adders directly produce data '1' supplied to at least one input terminal of three input terminals thereof from their sum output terminals thereof. More specifically, since the three full adders corresponding to the coefficients C1, C3, C4 of the processing units 8A, 8B, ... produce carry outputs '0' and also produce from their sum output terminals data '1' or '0' supplied thereto from full adders of one digit higher in the processing units of the preceding stage, these three adders can be removed.

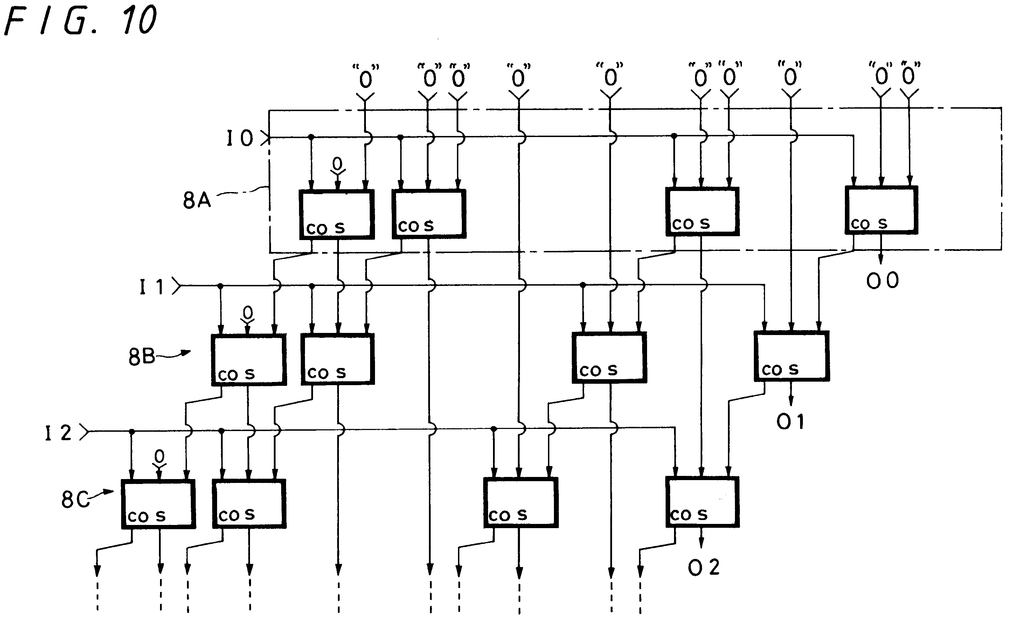

Figure 10 shows a multiplier circuit which results from removing these three hatched adders from the respective processing units of Figure 9. Since the multiplier circuit of Figure 10 is constructed by repeatedly connecting in cascade processing units 8A, 8B, ..., each of which includes four full adders, time division processing can be executed by feeding outputs of the respective adders through a register back to the input side. Figure 8 shows a multiplier circuit of this embodiment in which the multiplier circuit of Figure 6 is converted into a time division circuit. While input data I0, I1, ...In-1 are supplied at the same timing as in the multiplier circuit of Figure 10, input data I are serially supplied in such a manner as to supply input data I0 in the first cycle, input data I1 in the second cycle, ..., input data In-1 in the nth cycle in the circuit of this embodiment shown in Figure 8, whereby respective bits 0i of the product O of the input data I and the coefficient C are output from the output terminal 7 of Figure 8 in such a way as to supply 00 in the first cycle, 01 in the second cycle, ..., On+6 in the (n+7)th cycle. Accordingly, the multiplier circuit of Figure 8 is exactly equivalent to the multiplier circuit of serial input and serial shown in Figure 4.

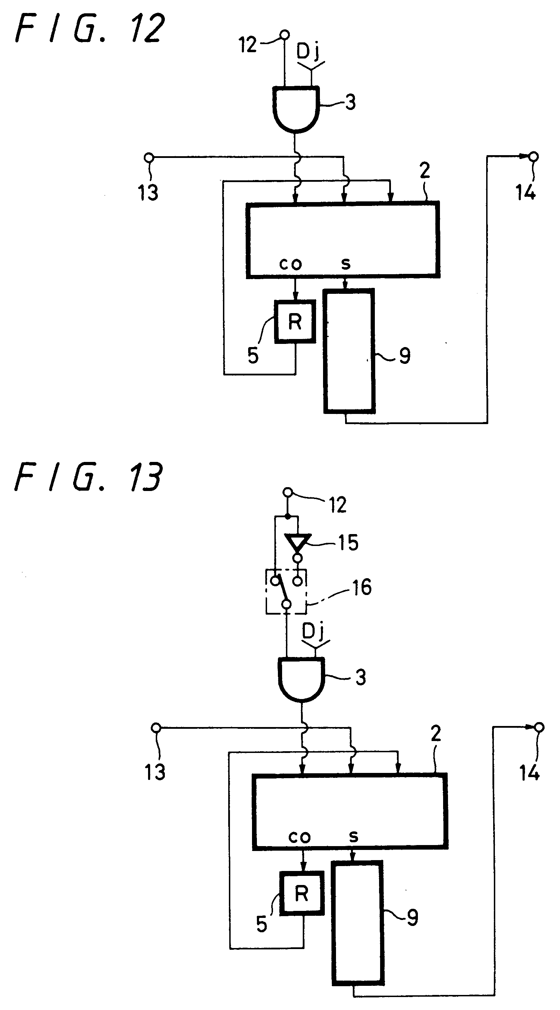

If the coefficient C is (100101), the $\text{D0 = D1 = D2 = 1}$ and D3 = 0 are set and delay times of variable delay circuits 9A to 9D are set to 0, 2 clocks, 3 clocks and 1 clock, respectively, in Figure 6. At that time, since the AND gates 3A to 3C directly generate their input data, and the output of the AND gate 3D becomes '0', the multiplier circuit of Figure 6 becomes equivalent to that of Figure 11, that is, the adder 2D of the maximum digit can be removed. Therefore, the multiplier circuit of Figure 11 can calculate the product O of the input data I and the coefficient (100101) in a serial input and output fashion.

Further, if a product of input data I and coefficient C (=10110001)) is calculated by the multiplier circuit of Figure 6, then $\text{D0 = D1 = D2 = D3 = 1}$ is set and delay times of the variable delay circuits 9A to 9D are set to 0, 4 clocks, 1 clock and 2 clocks, respectively. Similarly, when the number '1' in the coefficient C is below 4, then the product of the input data I and the coefficient C can be calculated by the multiplier circuit shown in Figure 6.

To generalize the multiplier circuit shown in Figure 6, a fundamental unit in the multiplier circuit shown in Figure 6 is represented in Figure 12. In the circuit of Figure 12, the fundamental unit comprises an AND gate 3 supplied at one and the other input terminals thereof with coefficient data Dj and data input from the outside through an input terminal 12. An adder 2 is supplied at first and second input terminals thereof with an output of the AND gate 3, and data supplied from the fundamental unit of the high order side through a connection terminal 13. A carry output of this adder 2 is fed through a register (R) 5 back to a third input terminal thereof, and a sum output of the adder 2 is supplied through the variable delay circuit 9 and a connection terminal 14 to the fundamental unit of lower order side. Then, if k of the fundamental units shown in Figure 12 are provided, then regardless of the word length of the coefficient C, the multiplication of serial input and output can be carried out so long as the coefficient C involves up to k'1's.

Generally, there is a 50% probability that each digit of the coefficient C is '1' or '0' and according to the arrangement of Figure 6, the number of adders can on average be reduced by half as compared with known arrangements.

A fundamental unit, which is provided by modifying the fundamental unit of Figure 12 as shown in Figure 13, can also be utilized. In the fundamental unit of Figure 13, data applied to an input terminal 12 from the outside is supplied to an inverter 15 and one input terminal of a two-input data selector 16, and an output of the inverter 15 is supplied to the other input terminal of the data selector 16. An output of the data selector 16 is supplied to one input terminal of the AND gate 3, and the coefficient data Dj is supplied to the other input terminal of the AND gate 3. The rest of the arrangement of Figure 13 is similar to that of Figure 12. The fundamental unit shown in Figure 13 is usable even when the value of a certain bit in the coefficient C is '-1'.

More specifically, when the bit Dj is '-1', then the output of the inverter 15 is selected by the data selector 15 and '1' is set as the output of the register 5 provided at the carry output side of the adder 2 upon reset, whereby an inverted value of input data and '1' are added. As a result, a value, which results from multiplying the input data by -1, is added to the coefficient. Further, if four fundamental units of Figure 13 are connected in parallel as shown in Figure 6, then the input data can be multiplied by, for example, coefficient (011111001111). The reason for this is as follows. The coefficient (011111001111) is the same as coefficient (10000-101000-1) and the latter coefficient involves only four bits which are not '0', so that the former coefficient (011111001111) can be calculated by a multiplier circuit in which four fundamental units of Figure 13 are connected in parallel.

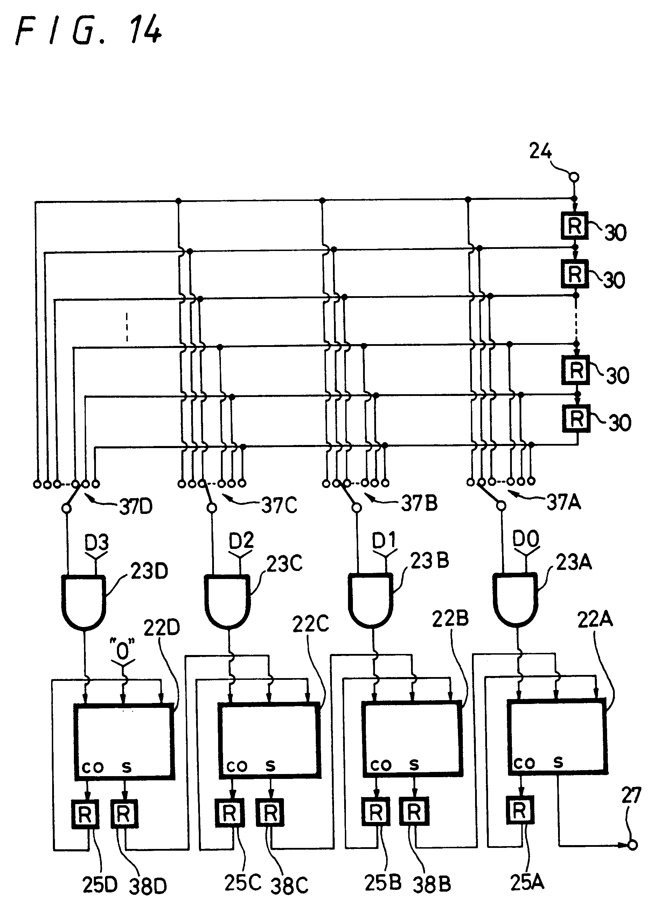

The multiplier circuit according to a second embodiment of the present invention will now be described with reference to Figure 14. Similarly to the example of Figure 6, this multiplier circuit calculates a product O of input data I serially input and a coefficient C of word length m bits having four '1's at maximum, and outputs respective bits of the calculated product O serially.

Figure 14 shows the multiplier circuit of this embodiment and as shown in Figure 14, (m-4) registers 30 are connected in cascade as a unit delay element and an input terminal of the leading register 30 is connected to an input terminal 24. At the input terminal of the leading register 30 and output terminals of the (m-4) registers 30 are developed data which result from the delaying input data I input to the input terminal 24 from the outside by 0 to (m-4) clocks, respectively. Data selectors 37A to 37D are of (m-3) input-one-output type, and data, which result from delaying the input data I by 0 to (m-4) clocks, are commonly supplied to the first to (m-3)th input terminals of the data selectors 37A to 37D. Outputs of the data selectors 37A to 37D are respectively supplied to one input terminal of AND gates 23A to 23D, and data D0 to D3 of bits which can become '1' in the coefficient C are respectively supplied to the other input terminal of AND gates 23A to 23D.

Also in this embodiment, four full adders 22A to 22D are utilized and sum outputs of the full adders 22B to 22D of the higher digit are respectively supplied through registers 38B to 38D provided as the unit delay element to input terminals of the full adders 22A to 22C of one digit lower. A product O, which is the sum output of the full adder 22A of the lowest digit is serially supplied to an output terminal 27. The rest of the arrangement of Figure 14 is the same as that of Figure 6.

In order to calculate a product of input data and a coefficient (11000101) by the multiplier circuit of Figure 14, $\text{D0 = D1 = D2 = D3 = 1}$ is set and data, which result from delaying the input data I by 0, 1 clock, 4 clocks and 4 clocks, are selected by the data selectors 37A to 37D. If they are set as described above, then the multiplier circuit of Figure 14 becomes equivalent to that of Figure 8 and thus the multiplier circuit of Figure 14 can multiply the input data I and the coefficient C similarly to the multiplier circuit of Figure 8. While the multiplier circuit shown in Figure 6 can process a variety of coefficients C by respectively changing the delay times in the variable delay circuits 9A to 9D as described above, the multiplier circuit of this embodiment shown in Figure 14 can process a variety of coefficients C by changing selected data in the data selectors 37A to 37D.

Comparing the sizes of the multiplier circuits shown in Figures 6 and 14, the variable delay circuits 9A to 9D in the multiplier circuit shown in Figure 6 comprise registers whose number is about four times as large as m, which is the word length of the coefficient C, and the number of the registers 30 and the registers 38B to 38D in the multiplier circuit shown in Figure 14 is about m. Accordingly, the multiplier circuit of Figure 14 can save about 3m registers as compared with the multiplier circuit of Figure 6, and hence the multiplier circuit of Figure 14 can be smaller.

Further, when the multiplier circuit shown in Figure 14 is generalized, if the word length of the coefficient C is m bits and k '1's exist with the m bits, then k full adders are utilized, delay circuits are composed of (m-k) registers, and data, which result from delaying the input data I by 0 to (m-k) clocks, are respectively supplied to AND gates connected to the input sides of the respective full adders, whereby a serial input and serial output multiplier circuit is formed. Similarly to the multiplier circuit of Figure 13, the multiplier circuit shown in Figure 14 can multiply input data I and the coefficient C having bits '-1', by adding a circuit formed of an inverter and a data selector to the input portion thereof.

In this embodiment, if the register holds undefined data when the LSB of the input data I is input at the first cycle, then such undefined data are erroneously added by the adders, and therefore values held by all registers must in practice be cleared by a clear signal supplied thereto from the outside. While the clear signal may be supplied to all registers at the same timing in the first embodiment shown in Figure 6, respective registers must be cleared at different timings in accordance with the delay times from the input terminal 4 to the full adders in the second embodiment shown in Figure 14.

With the multiplier circuits of the first and second embodiments, since full adders of those digits are removed if the coefficient multiplied with the input data involves a bit '0', the number of the full adders utilized can generally be reduced.

Moreover, with the multiplier circuit of the second embodiment, since a plurality of variable delay circuits in the multiplier circuit in the first embodiment can be replaced with a single delay circuit, the circuit scale can be made smaller.

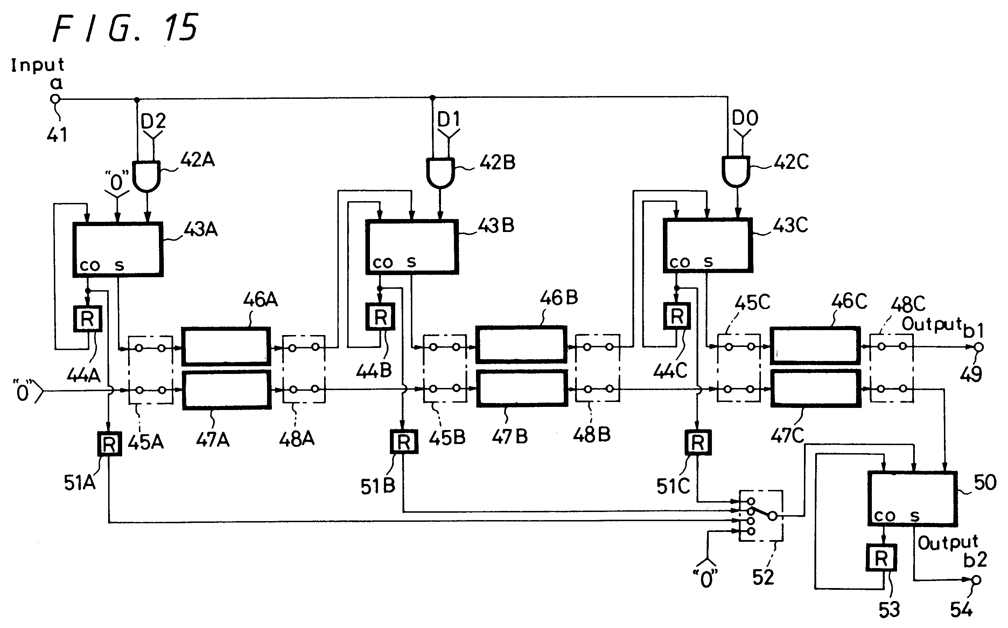

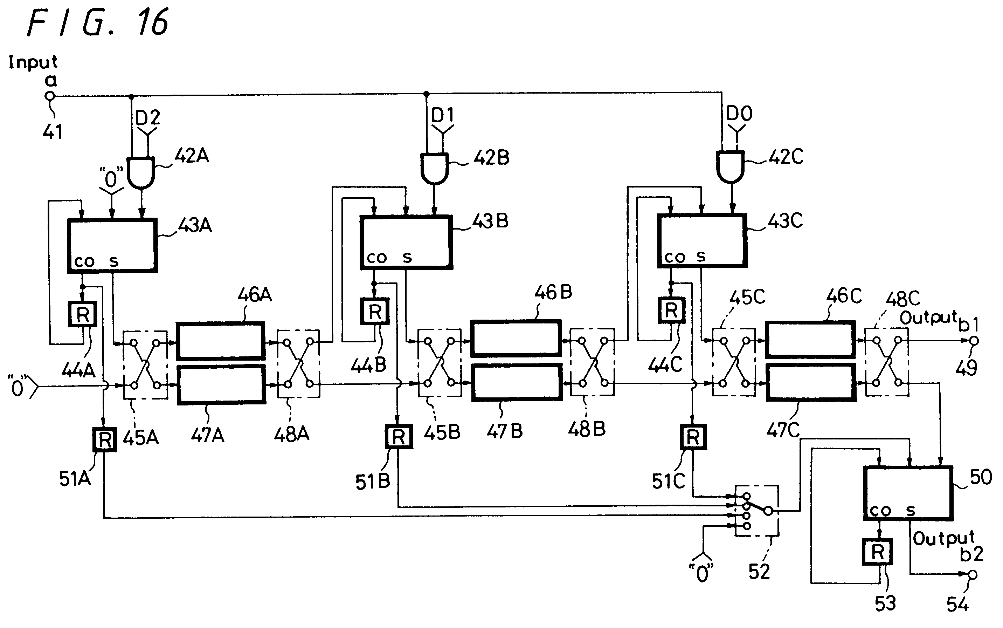

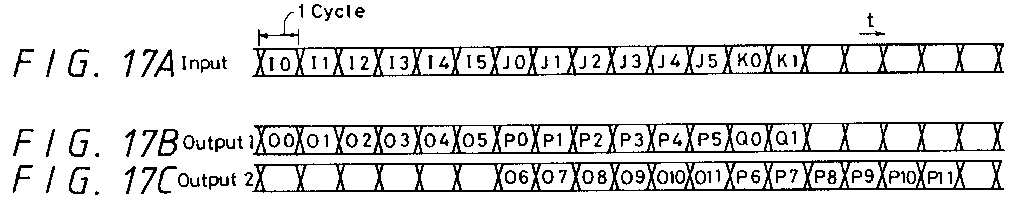

A serial input multiplier circuit according to the third embodiment of the present invention will be described with reference to Figures 15 and 16. In this embodiment, a coefficient C of a predetermined word length, that is, six bits, is multiplied with input data I, J, K, ... of word length six bits serially input, and resultant products O, P, Q, ... of word length twelve bits are serially output via two output lines. In this case, let it be assumed that input data I, coefficient C and product O (=IxC) are expressed in a binary numeral fashion by the foregoing equation (2) as:$\begin{matrix}\begin{matrix}\text{I = (I5, I4, I3, I2, I1, I0)} \\ \text{C = (C5, C4, C3, C2, C1, C0)} \\ \text{O = IxC = (011, 010, 09, ..., 01, 00)}\end{matrix}\end{matrix}$ and other input data J, product P and so on can be expressed similarly in a binary fashion. In this embodiment, it is assumed that respective bits of input data I, J, K, ... are successively supplied as shown in Figure 17A and the lower six bits of products O, P, Q, ... are successively output via one output line in response thereto as shown in Figure 17B, while the higher six bits of these products are successively output via the other output line as shown in Figure 17C.

In this embodiment, it is assumed that the coefficient C involves three bits which may become '1', and that three bits of data are represented as coefficient data D0, D1 and D2 in the order of less significant digits. For example, if C=(110010), then $\text{D0=D1=D2=1}$, while if C=(001001), then $\text{D0=D1=1}$ and D2=0.

Figure 15 shows the multiplier circuit of this embodiment. In Figure 15, reference numeral 41 depicts an input terminal. Input data a are commonly supplied to one input terminal of AND gates 42A to 42C through the input terminal 41 from the outside, and coefficient data D2 to D0 are supplied to the other input terminal of the AND gates 42A to 42C. In this case, as the input data a, input data I, J, K, ... are serially and successively supplied to the input terminal 41 as shown in Figure 17A. Outputs of the AND gates 42A to 42C are respectively supplied to first input terminals of adders 43A to 43C, and carry outputs of the adders 43A to 43C are respectively supplied through registers 44A to 44C, each provided as a unit delay element, to second input terminals of their own.

Two input and two output data exchanging or switching circuits 45A to 45C and 48A to 48C directly output two inputs in parallel, or cross and output the two inputs in response to a control signal from the outside. Variable delay circuits 46A to 46C and 47A to 47C each delay input data by delay times of one clock to six clocks in response to a control signal supplied thereto from the outside. Data '0' are supplied to a third input terminal of the full adder 43A of the highest digit and a sum output terminal S of the full adder 43A is connected to a first input terminal of the data switching circuit 45A. Data '0' are supplied to a second input terminal of the data switching circuit 45A and first and second output terminals of the data switching circuits 45A are respectively connected through the variable delay circuits 46A and 47A to first and second input terminals of the data switching circuit 48A.

A first output terminal of the data switching circuit 48A is connected to a third input terminal of the full adder 43B of the middle digit, and a sum output terminal of the full adder 43B and a second output terminal of the data switching circuit 48A are respectively connected to the first and second input terminals of the data switching circuit 45B. The first and second output terminals of the data switching circuit 45B are respectively connected through the variable delay circuits 46B and 47B to the first and second input terminals of the data switching circuit 48B. The first output terminal of the data switching circuit 48B is connected to a third input terminal of the full adder 43C of the lowest digit, and a sum output terminal of the full adder 43C and the second output terminal of the data switching circuit 48B are respectively connected to first and second input terminals of the data switching circuit 45C.

First and second output terminals of the data switching circuit 45C are respectively connected through the variable delay circuits 46C and 47C to the first and second input terminals of the data switching circuit 48C. Then, data b1 developed at the first output terminal of the data switching circuit 48C are supplied to an output terminal 49, and the second output terminal of the data switching circuit 48C is connected to a first input terminal of an additional full adder 50. Registers 51A to 51C are respectively provided as unit delay elements, and a data selector 52 is of a four-input and one-output type. Carry outputs of the adders 43A to 43C are supplied respectively through the registers 51A to 51C to first to third input terminals of the data selector 52 and data '0' are supplied to a fourth input terminal of the data selector 52. An output of the data selector 52 is supplied to the second input terminal of the adder 50, and a carry output of the adder 50 is fed through a register 53, provided as the unit delay element, back to the third input terminal of the adder 50. Then, a sum output b2 of the adder 50 is supplied to an output terminal 54. The above-mentioned data b1 represents six bits of lower digits in a serial product shown in Figure 17B, and the data b2 represents six bits of higher digits in a serial product shown in Figure 17C.

The operation of the multiplier circuit shown in Figure 15 will be described below in the case where the coefficient C is assumed to be (110010). In this case, $\text{D0=D1=D2=1}$ is set, while the delay times of the variable delay circuits 46A, 47A are set to one clock, those of the variable delay circuits 46B, 47B are set to three clocks, and those of the variable delay circuits 46C, 47C are set to one clock, respectively. In this embodiment, data of twelve bits of the product O of the input data I and the coefficient C is obtained during a series of twelve cycles, while data f six lower bits of the product P of the next input data J and the coefficient C is obtained in parallel during six cycles of the second half period of twelve cycles. In this case, assuming that Ii represents data f one bit input from the input terminal 41, then the AND gates 42A to 42C output data Ii.C which is regarded as one partial product of the input data I and the coefficient C.

During the first to sixth cycles of the first half period of twelve cycles, data I0, I1, ..., I5 are sequentially input to this multiplier circuit from the input terminal 41 of Figure 15, and during this period, the data switching circuits 45A to 45C and the data switching circuits 48A to 48C are respectively set to directly output two input data in parallel as shown in Figure 15. In that event, the adders 43A to 43C are connected in a pipeline system and partial products of the input data and the coefficient C calculated by the AND gates 42A to 42C are sequentially supplied to the full adders 43A to 43C so that six lower bits O0, O1, ..., O5 of the product O are serially output from the output terminal 49.

At the end of the sixth cycle, six higher bits of the product O are expressed as redundant bits by the sum and the carry. That is, a sum of 7th bit of the product O is still held in the variable delay circuit 46C, a sum of 8th to 10th bits of the product O is still held in the variable delay circuit 46B and a sum of the 11th bit of the product O is still held in the variable delay circuit 46A, respectively. Further, the carry value to the 8th bit is still output as the carry output of the adder 43C, the carry value to the 11th bit is still output as the carry output of the adder 43B, and the carry value to the 12th bit is still output as the carry output of the adder 43A, respectively.

Accordingly, at the completion of the sixth cycle, the carry output (carry to the 8th bit) of the adder 43C, the carry output (carry to the 11th bit) of the adder 43B and the carry output (carry to the 12th bit) of the adder 43A are respectively held in the registers 51C, 51B and 51A. The registers 51A to 51C continue to hold the above-mentioned values during the next period of 7th to 12th cycles, respectively.

During the period of 7th to 12th cycles, as shown in Figure 16, the data switching circuits 45A to 45C and the data switching circuits 48A to 48C respectively set to switch and then output their two input data. As a consequence, as shown in Figure 16, the variable delay circuits 46A, 46B and 46C are connected serially so that sums of 7th bit to 11th bit data which are the redundant expressions of the product O are sequentially input to the first input terminal of the full adder 50. While, data held by the registers 51C to 51A or data '0' are supplied through the data selector 52 to the second input terminal of the adder 50, and the selection of data by the data selector 52 can be controlled from the outside.

Referring to Figure 16, while the sum of 7th bit of data which are the outputs of the variable delay circuits 46A to 46C serially connected is input to the adder 50 at the 7th cycle, the data selector 52 is controlled from the outside so as to supply data '0' to the adder 50 because the carry is never added to the 7th bit. As a result, the addition is not carried out by the adder 50, and the sum of 7th bit data output from the variable delay circuits 46A to 46C is directly supplied to the output terminal 54 as 7th bit data 06. Moreover, while the sum of 8th bit of data output from the variable delay circuits 46A to 46C is input to the adder 50 at the 8th cycle, the data selector 52 is controlled from the outside so as to input data held in the register 51C to the adder 50 because the carry of the 8th bit held in the register 51C must be added to the above-mentioned value. As a consequence, the 8th bit sum and the carry to the 8th bit are added by the adder 50, and the sum output of the added result is supplied to the output terminal 54 as 8th bit data O7 of the product O. Furthermore, a carry to the next bit produced by the addition of the adder 50 is added to the next data via the register 53 during the next cycle.

Although sums of 9th bit and the following bits are supplied to the adder 50 from the variable delay circuits 46A to 46C during a period following the 9th cycle similarly, the 11th bit carry held in the register 51B and the 12th bit carry held in the register 51A must be added by the adder 50 during the cycle in which the sum of 11th bit and the sum of 12th bit are supplied. For this reason, the data selector 52 is controlled from the outside so as to supply the data held in the registers 51B and 51A to the full adder 50. As a result, during the period from the 7th cycle to the 12th cycle, O6 to O11 which are data of the 7th bit to 12th bit of the product O are supplied to the output terminal 54.

In this embodiment, since the input data I, J, K, ... are successively supplied at timings shown in Figure 17A, respective bits J0 to J5 of the next data J are supplied to the input terminal 41 from the outside during the period from 7th cycle to 12th cycle. As is apparent from Figure 16, the full adders 43A to 43C and the variable delay circuits 47A to 47C form a serial-input-output multiplier circuit for lower bits which processes the input data J. More specifically, during the 7th to 12th cycles, the variable delay circuits 46A to 46C are utilized for the input data I, and the variable delay circuits 47A to 47C are utilized for the input data J. During the next 13th to 18th cycles, the connected states of the data switching circuits 45A to 45C and of the data switching circuits 48A to 48C are returned to those of Figure 15, wherein the variable delay circuits 47A to 47C are utilized in order to obtain the upper six bits of a product corresponding to the input data J, and the variable delay circuits 46A to 46C are utilized in order to obtain the lower six bits of a product corresponding to the next input data K. Thus, the variable delay circuits 46A to 46C and the variable delay circuits 47A to 47C are alternately utilized for data J, K, ..., successively input.

As described above, with the third embodiment, the products O, P, Q, ..., of input data and the coefficient C are serially output through the two output terminals 49 and 54 in the separate form of the lower six bits and the upper six bits. There is then the advantage that the data I, J, K, ... can be serially and successively input and multiplied with the coefficient C. Further, since the successive multiplication is executed only by switching the connected states of mainly the data switching circuits 45A to 45C and 48A to 48C at every six cycles, the control thereof can be facilitated considerably. Furthermore, with this embodiment, since it is sufficient to utilize the full adders 43A to 43C of number corresponding to the number of bits which may become '1' even when the coefficient C is formed of many bits, there is then the advantage that the multiplier circuit of this embodiment can be made smaller.

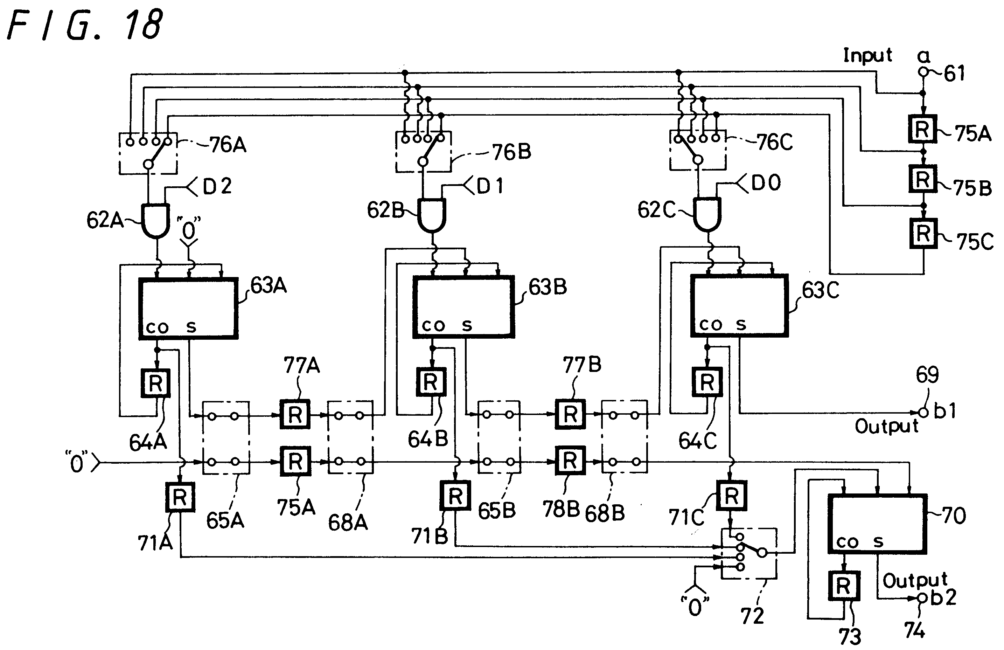

While the variable delay circuits 46A to 46C and 47A to 47C are independently provided in the multiplier circuit shown in Figure 15, Figure 18 shows an arrangement of a modified example thereof in which these variable delay circuits are made common.

Referring to Figure 18, it will be seen that registers 75A to 75C, each provided as a unit delay element, are successively connected to an input terminal 61, in that order. The input terminal 61 and output terminals of the registers 75A to 75C are commonly connected to first to fourth input terminals of data selectors 76A to 76C each of which is a four-input and one-output data selector, and output terminals of these data selectors 76A to 76C are respectively connected to one input terminals of AND gates 62A to 62C.

Further, first and second output terminals of a data switching circuit 65A are respectively connected to first and second input terminals of a data switching circuit 68A through registers 77A and 78A, each of which is provided as a unit delay element. First and second output terminals of a data switching circuit 65B are respectively connected to first and second input terminals of a data switching circuit 68B through registers 77B and 78B, each of which is provided as a unit delay element. A sum output terminal of a full adder 63C is connected to an output terminal 69 and a second output terminal of the data switching circuit 68B is connected to a first input terminal of a full adder 70. The rest of the arrangement of Figure 18 is the same as that of Figure 15 and therefore need not be described. While the multiplier circuit of Figure 18 can perform the multiplication at the timings shown in Figures 17A to 17C in a serial input and output fashion, the number of the registers utilized in the multiplier circuit of Figure 18 is reduced as compared with that of Figure 15, whereby the circuit of Figure 18 can be made smaller.

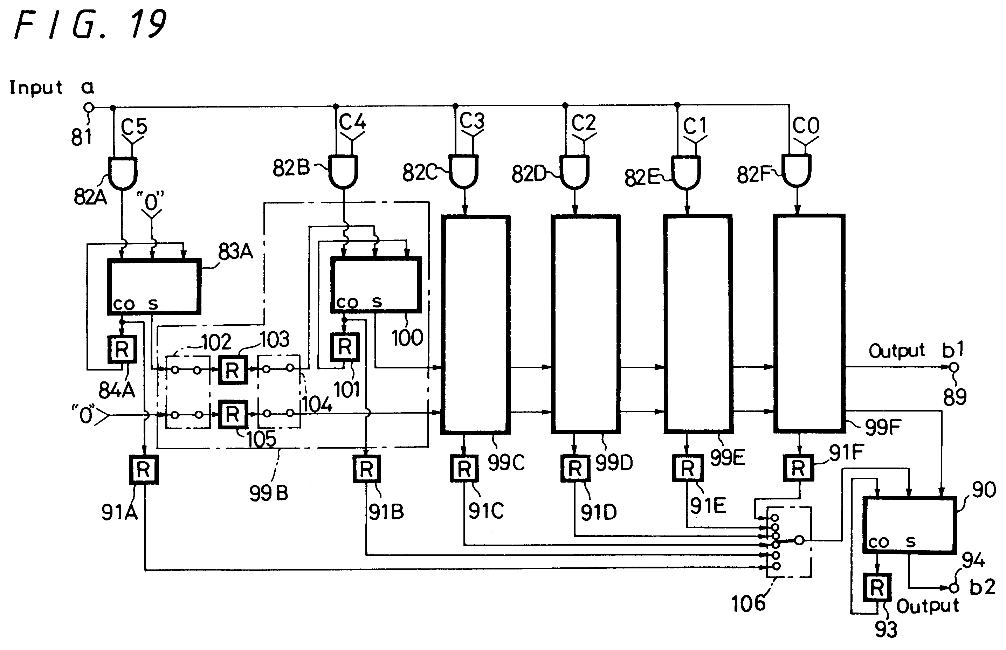

A fourth embodiment of the present invention will be described with reference to Figure 19. In this embodiment, the invention is applied to a serial-input and output multiplier circuit without modification. The multiplier circuit of this embodiment multiplies the input data I, J, ..., of word length six bits serial input as shown in Figure 19A with the coefficient C (=C5, C4, ..., C0) of word length six bits thereby serially to output resultant products O, P, ..., at every bit.

Referring to Figure 19, data a input to an input terminal 81 is commonly supplied to one input terminals of AND gates 82A to 82F and data C5 to C0 of respective bits of the coefficient C are respectively supplied to the other input terminals of these AND gates 82A to 82F. An output of the AND gate 82A of the maximum digit is supplied to a first input terminal of a full adder 83A and data '0' are supplied to a second input terminal of the adder 83A. A carry output of the adder 83A is fed through a register 84A to a third input terminal of the adder 83A, and the carry output of the adder 83A is further supplied to a register 91A. Then, outputs of the AND gates 82B to 82G are respectively supplied to processing units 99B to 99F, each of which has the same circuit configuration.

In the processing unit 99B, an output of the AND gate 82B is supplied to a first input terminal of a full adder 100 and a first output terminal of a data switching circuit 104, which will be described later, is connected to a second input terminal of the full adder 100. A carry output of the full adder 100 is fed through a register 101, provided as a unit delay element, back to a third input terminal of the full adder 100, and the carry output of the full adder 100 is further supplied to a register 91B. In Figure 19, reference numerals 102 and 104 depict two input and two output data switching circuits, and these data switching circuits 102 and 104 directly output two input data in parallel or switch the two input data in response to a control signal supplied thereto from the outside. A sum output of the adder 83A and data '0' are respectively supplied to first and second input terminals of the data switching circuit 102, and first and second output terminals of the data switching circuit 102 are connected to the first and second input terminals of the data switching circuit 104 via registers 103 and 105, each of which is provided as a unit delay element. A sum output of the adder 100 and data developed at the second output terminal of the data switching circuit 104 are supplied to a processing unit 99C of the next stage.

Similarly, two outputs of the processing units 99C to 99E are respectively supplied to the next processing units 99D to 99F, and carry outputs of full adders (not shown) provided within these processing units 99C to 99F are respectively supplied to registers 91C to 91F. Then, a sum output of a full adder (not shown) provided within the processing unit 99F of the final stage is supplied to an output terminal 89 as data b1, and output data developed at a second output terminal of a data switching circuit (not shown) of the processing unit 99F is supplied to a first input terminal of the full adder 90. Also, a carry output of the full adder 90 is fed through a register 93 back to a second input terminal of the full adder 90. In Figure 19, reference numeral 106 depicts a six-input and one-output data selector, and data held in the registers 91A to 91F are respective supplied to six input terminals of the data selector 106. An output of the data selector 106 is supplied to the third input terminal of the adder 90 and a sum output of the adder 90 is supplied to an output terminal 94 as data b2.

Also in this embodiment, as shown in Figure 17A, input data I, J, K, ... of six bits are serially supplied to the input terminal 81 and the data switching circuits 102 and 104 in the processing units 99B to 99F are switched at every six cycles, whereby the products O, P, Q, ... are respectively and serially output from the output terminals 89 and 94 as shown in Figures 17B and 17C. However, the circuit configuration of Figure 19 needs the full adders of number substantially the same as that of the word length of the coefficient C, and therefore the multiplier circuit shown in Figure 19 is large compared with that of Figure 15.

In the multiplier circuit of Figure 15, the word length of the input data is six bits, and the word length of the output data is twelve bits, that is, the output data have a word length twice as large as the word length of the input data, with the result that the variable delay circuits 47A to 47C are further provided in parallel with the variable delay circuits 46A to 46C, respectively. On the other hand, when the word length of input data is six bits and the word length of the coefficient C is twelve bits, then the word length of the output data is eighteen bits. At that time, since the word length of the output data is as long as three times that of the input data, it is sufficient that variable delay circuits of a third group are additionally provided in parallel with the variable delay circuits 47A to 47C.

While the multiplier circuits of Figures 15 and 18 are applied to the case such that the coefficient C involves three '1's or less, the multiplier circuits of Figures 15 and 18 can be expanded with ease into the case such that a word length of the coefficient C is generally m bits, and that the coefficient C involves k '1's. Similarly, the multiplier circuit of Figure 19 can be generally expanded into the case such that the word length of the coefficient C is m bits.

With the present embodiments, since the products of input data and the predetermined coefficient are output from the sum output terminals of the full adder of the minimum digit of a plurality of full adders and the additional full adder, input data can be successively and the processing speed can be increased.

## Claims

1. A serial-input-output multiplier circuit comprising:
- calculating circuits (3) each calculating a partial product of respective digits of one serially supplied number and another number;
- a plurality of full adders (2) supplied at input portions thereof with said partial products serially through said calculating circuits;
- unit delay elements (5) for respectively supplying carry outputs of said plurality of full adders (2) to the input portions of said full adders (2); and
- variable delay circuits (9) for respectively supplying sum outputs of said full adders (2) of more significant digits to the input portions of said full adders (2) of less significant digits, the respective delays being set according to the "0" digits in said another number;
wherein a product of said one number and said other number is serially obtained as a sum output of said full adder (2) of the least significant digit.

2. A serial-input-output multiplier circuit comprising:
- a delay circuit having a plurality of unit delay elements (30) each having an output, said unit delay elements being connected in cascade and to which one number is serially supplied;
- a plurality of AND circuits (23) supplied at one input terminal thereof with another number, digits of which may be "1";
- means (37) for supplying to the other input terminal of each of said plurality of AND circuits (23), an output separately selected from said outputs of said plurality of unit delay elements (30) for each of said plurality of AND circuits (23);
- a plurality of full adders (22) the inputs of which are arranged to receive respective outputs of said plurality of AND circuits (23);
- a plurality of unit delay elements (25) through which carry outputs of said plurality of full adders (22) are respectively fed back to input portions of said plurality of full adders (22); and
- a plurality of unit delay elements (38) through which sum outputs of said full adders (22) of more significant digits are respectively supplied to the input portions of said full adders (22) of less significant digits;
wherein a product of said one number and said other number is serially obtained as a sum output of said full adder (22) of the least significant digit.

## Patentansprüche

1. Multiplizierer-Schaltung mit seriellem Eingang und seriellem Ausgang, welche umfaßt:
Berechnungsschaltungen (3), wobei jede ein Partialprodukt von entsprechenden Ziffern einer seriell-gelieferten Zahl und einer weiteren Zahl berechnet;
mehrere Volladdierer (2), die an ihren Eingängen mit den Partialprodukten durch die Berechnungsschaltungen seriell beliefert werden;
Einheit-Verzögerungselemente (5) zum entsprechenden Liefern von Übertrag-Ausgangssignalen der mehreren Volladdierer (2) zu den Eingängen der Volladdierer (2); und
variable Verzögerungsschaltungen (9), um entsprechend Summenausgangssignale der Volladdierer (2) von höherwertigeren Ziffern zu den Eingängen der Volladdierer (2) von niedrigwertigeren Ziffern zu liefern, wobei die entsprechenden Verzögerungen gemäß den "0"-Ziffern in der anderen Zahl gesetzt sind;
wobei ein Produkt der einen Zahl und der anderen Zahl seriell als ein Summenausgangssignal des Volladdierers (2) der niedrigstwertigsten Ziffer erhalten wird.

2. Multiplizierer-Schaltung mit seriellem Eingang und seriellem Ausgang, welche umfaßt:
eine Verzögerungsschaltung, die mehrere Einheit-Verzögerungselemente (30) aufweist, wobei jedes einen Ausgang hat, wobei die Einheit-Verzögerungselemente kaskadenförmig geschaltet sind und zu denen eine Zahl seriell geliefert wird;
mehrere UND-Schaltungen (23), die an ihrem einen Eingangsanschluß mit einer anderen Zahl beliefert werden, wobei Ziffern davon "1" sein können;
eine Einrichtung (37) zum Liefern eines Ausgangssignals zum anderen Eingangsanschluß jeder der mehreren UND-Schaltungen (23), welches separat von den Ausgangssignalen der mehreren Einheit-Verzögerungselemente (30) für jede der mehreren UND-Schaltungen (23) ausgewählt wird;
mehrere Volladdierer (22), deren Eingänge so eingerichtet sind, entsprechende Ausgangssignale der mehreren UND-Schaltungen (23) zu empfangen;
mehrere Einheit-Verzögerungselemente (25), über welche Übertrag-Ausgangssignale der mehreren Volladdierer (22) entsprechend zurück zu den Eingängen der mehreren Volladdierer (22) geführt werden; und
mehrere Einheit-Verzögerungselemente (38), über welche Summenausgangssignale der Volladdierer (22) der höherwertigeren Ziffern entsprechend zu den Eingängen der Volladdierer (22) der niedrigwertigeren Ziffern geliefert werden;
wobei ein Produkt der einen Zahl und der anderen Zahl seriell als ein Summenausgangssignal des Volladdierers (22) der niedrigstwertigsten Ziffer erhalten wird.

## Revendications

1. Circuit multiplicateur à entrée-sortie série comprenant :
des circuits de calcul (3) dont chacun calcule un produit partiel de chiffres respectifs d'un nombre fourni en série et d'un autre nombre ;
une pluralité d'additionneurs complets (2) auxquels sont fournis à des parties d'entrée de ceux-ci lesdits produits parties en série par lesdits circuits de calcul ;
des éléments à retard d'une unité (5) pour fournir respectivement des signaux de retenue de sortie de ladite pluralité d'additionneurs complets (2) aux parties d'entrée desdits additionneurs complets (2) ; et,
des circuits à retard variable (9) pour fournir respectivement des signaux de somme de sortie desdits additionneurs complets (2) de chiffres de poids plus forts aux parties d'entrée desdits additionneurs complets (2) de chiffres de poids plus faibles, les retards respectifs étant établis conformément aux chiffres "0" dans ledit autre nombre ;
dans lequel un produit dudit un nombre et dudit autre nombre est obtenu en série comme signal de somme de sortie dudit additionneur complet (2) du chiffre de poids le plus faible.

2. Circuit multiplicateur à entrée-sortie série comprenant :
un circuit à retard comportant une pluralité d'éléments à retard d'une unité (30) ayant chacun une sortie, lesdits éléments à retard d'une unité étant connectés en cascade et un nombre étant fourni en série à ceux-ci ;
une pluralité de circuits ET (23) auxquels est fourni à une borne d'entrée de ceux-ci un autre nombre dont les chiffres peuvent être "1" ;
des moyens (37) pour fournir à l'autre borne d'entrée de chacun de ladite pluralité de circuits ET (23), un signal de sortie sélectionné séparément dans lesdits signaux de sortie de ladite pluralité d'éléments à retard d'une unité (30) pour chacun de ladite pluralité de circuits ET (23) ;
une pluralité d'additionneurs complets (22) dont les entrées sont disposées pour recevoir des signaux de sortie respectifs de ladite pluralité de circuits ET (23) ;
une pluralité d'éléments à retard d'une unité (25) par lesquels des signaux de retenue de sortie de ladite pluralité d'additionneurs complets (22) sont respectivement renvoyés à des parties d'entrée de ladite pluralité d'additionneurs complets (22) ; et,
une pluralité d'éléments à retard d'une unité (38) par lesquels des signaux de somme de sortie desdits additionneurs complets (22) de chiffres de poids plus forts sont respectivement fournis aux parties d'entrée desdits additionneurs complets (22) de chiffres de poids plus faibles ;
dans lequel un produit dudit un nombre et dudit autre nombre est obtenu en série comme signal de somme de sortie dudit additionneur complet (22) du chiffre de poids le plus faible.
